# EUROPÄISCHE PATENTSCHRIFT

(11) **EP 1 578 016 B1**
(45) Veröffentlichungstag und Bekanntmachung des Hinweises auf die Patenterteilung: **27.12.2006**
(21) Anmeldenummer: 04006140.0
(22) Anmeldetag: 15.03.2004
(51) Int. Cl.: H03J 1/00

(54) **Programmierbarer Fernsteuersender, insbesondere Infrarot-Fernsteuersender und Programmiereinrichtung zum Programmieren des Fernsteuersenders**
Programmable remote control, in particular infrared remote control and programming device for programming the remote control
Télécommande programmable, en particulier télécommande programmable à infrarouge et dispositif de programmation de la télécommande

(43) Veröffentlichungstag der Anmeldung: 21.09.2005
(73) Patentinhaber: Ruwido Austria Gesellschaft M.B.H., 5202 Neumarkt a.W. (AT)
(72) Erfinder: Jäkel, Günter, 83257 Gollenshausen (DE)
(74) Vertreter: von Bülow, Tam

(56) Entgegenhaltungen:
- FR-A- 2 696 888
- US-B1- 6 211 856
- US-B1- 6 211 870

## Beschreibung

Die Erfindung bezieht sich auf ein Verfahren zum Programmieren eines Fernsteuersenders gemäß dem Oberbegriff des Patentanspruches 1.

Die US 6 211 870 B1 beschreibt ein Verfahren zur Programmierung eines Fernsteuersenders. Dabei wird ein Mehrzweckcomputer verwendet, der die üblichen Baugruppen, wie Prozessor, Kurzzeitspeicher, Langzeitspeicher, graphisches Display und Eingabeeinrichtung, aufweist. Der Fernsteuersender enthält ebenfalls die üblichen Baugruppen, wie Mikroprozessor, Speicher, Eingabeschnittstelle und Energieversorgung. Als Bedieneinheit ist dort ein Sensorbildschirm, sog. Touch-Screen, vorgesehen, auf dem Bilddaten in Form einer Tastatur dargestellt werden. Wird ein entsprechender Bereich dieses Sensorbildschirmes berührt, so werden zuvor einprogrammierte Befehlsdaten aus dem Speicher abgerufen und an ein zu bedienendes Gerät, wie z.B. ein Fernsehgerät, übertragen. Mit dieser Lösung soll eine programmierbare Universalfernsteuerung für die verschiedensten fernsteuerbaren Geräte geschaffen werden, wobei der Endbenutzer über einen üblichen Computer mit entsprechender Software die Programmierung für seine vorhandenen Geräte einfach durchführen kann.

Fernsteuersender und Programmiereinrichtungen hierfür sind auch aus der DE 40 25 302 C2 bekannt.

Viele technische Geräte, wie z.B. Fernsehgeräte, Videorecorder, Satellitenempfänger, DVD-Abspielgeräte, Musikanlagen etc., werden heute mit Infrarot-Fernsteuersendern bedient. Normalerweise ist für jedes dieser Geräte ein eigener Fernsteuersender vorhanden. Damit sich die einzelnen Fernsteuersender gegenseitig nicht stören, haben sie unterschiedliche Codes, die als Infrarot-Signale ausgesandt werden. Die Codierung kann durch die Modulationsart, die Frequenz, Impuls- und/oder Pausenlänge, Tastverhältnis, Tastfrequenz etc. codiert werden. Grob geschätzt gibt es derzeit mehrere tausend verschiedene Codes. Darüber hinaus haben die einzelnen Fernsteuersender auch ein unterschiedliches Aussehen und eine unterschiedliche Anzahl, Anordnung und Beschriftung der einzelnen Bedientasten, denen jeweils gerätespezifische Funktionen bzw. Codes zugewiesen sind.

Ein Problem der Fernsteuersender ist ihre Lebensdauer, die häufig geringer ist als die des zugeordneten Gerätes, sei es wegen unsachgemäßer Behandlung, wie z.B. Herunterfallen, Auslaufen von Batterien oder wegen Funktionsstörungen einzelner Tasten aufgrund häufiger Betätigung. Aufgrund der Vielzahl unterschiedlicher Fernsteuersender ist es für Händler und Reparaturbetriebe nicht möglich, alle gängigen Typen von Fernsteuersendern auf Lager zu halten, falls der Austausch erforderlich wird. Auch die Hersteller sind in der Praxis zu einer solchen Lagerhaltung nicht bereit und aufgrund häufiger Modellwechsel auch nicht in der Lage, bestimmte Fernsteuersender nachzuproduzieren.

Aus diesem Grunde gibt es universelle programmierbare Fernsteuerungen, wie beispielsweise in der eingangs genannten DE 40 25 302 C2 oder der US 4,623,887, US 4,628,848, EP 0 117 121 A2 und EP 0 354 313 A2 beschrieben.

Die meisten bekannten programmierbaren Fernsteuersender enthalten einen Mikroprozessor, einen programmierbaren Speicher, in den Codes einspeicherbar sind, eine Eingabeschnittstelle für die Eingabe von Codes in den Speicher, eine Bedieneinheit in Form einer Tastatur und eine Ausgabeschnittstelle mit einer Infrarot-Sendeeinheit. Die Programmierung eines solchen Fernsteuersenders erfolgt über die Eingabeschnittstelle. Die benötigten Codes werden zumindest Händlern und Reparaturwerkstätten von den Herstellern zur Verfügung gestellt, wie z.B. auf Datenträgern oder über das Internet.

Es sind auch IR-Fernsteuersender erhältlich, die bereits eine große Anzahl unterschiedlicher Codes gespeichert haben und vom Endbenutzer dadurch selbst auf sein entsprechendes Gerät "programmiert" werden können, daß er bestimmte Tastenkombinationen betätigt und dadurch einen hersteller- und gerätespezifischen Codevorrat aktiviert. Auch verfügen diese von der Anmelderin unter dem Namen "Easytip" vertriebenen Fernsteuersender über die Möglichkeit, mehrere Geräte, wie z.B. Fernseher, Videorecorder, Satellitenempfänger, Musikanlagen, fernzubedienen, wobei das jeweilige Gerät, d.h. der zugeordnete Code durch vorgegebene Tasten oder Schalter ausgewählt wird. Je nach ausgewähltem Gerät sind dann den einzelnen Tasten unterschiedliche Funktionen zugewiesen.

Die bisherigen bekannten programmierbaren Fernsteuersender haben jedoch einige Probleme:
Sie haben eine fest vorgegebene Anzahl von Tasten, die nur in seltensten Fällen mit der Tastenzahl des Originalgerätes übereinstimmt, was zur Folge hat, daß der programmierbare Fernsteuersender entweder zu viele Tasten hat, von denen einige nicht belegt sind oder zu wenig Tasten, so daß er bestimmte Funktionen nicht ausführen kann. Weiter stimmt die Anordnung der Tasten nicht mit der des original Gerätes überein, was auch für die Beschriftung der Tasten gilt. Hierdurch wird es für den Endbenutzer mühsam, sich an die neue Tastatur zu gewöhnen. Noch schwieriger wird es für den Benutzer, wenn er mit ein und demselben Fernsteuersender mehrere Geräte bedienen will, weil dann, je nach aktiviertem Gerät, die einzelnen Tasten unterschiedliche Funktionen auslösen.

Aufgabe der Erfindung ist es daher, das Verfahren der eingangs genannten Art dahingehend zu verbessern, daß der Fernsteuersender hinsichtlich seiner Bedienbarkeit jedem beliebigen Fernsteuersender nahezu identisch anpaßbar ist. Diese Aufgabe wird durch die im Patentanspruch 1 angegebenen Merkmale gelöst.

Die Grundidee der Erfindung liegt darin, die bisherige Tastatur und deren Aussehen (Layout) durch einen programmierbaren Sensorbildschirm (sog. Touchscreen) zu ersetzen. Dieser Sensorbildschirm hat somit eine Doppelfunktion, nämlich die einer Anzeige (Bildschirm), wie z.B. einer LCD-Anzeige, und die einer Bedieneinheit, wie z.B. einer Tastatur. Diese beiden Funktionen (Anzeige und Bedieneinheit) können sowohl in einer einzigen mehrschichtigen Folie vereinigt sein, als auch in hintereinander liegenden Einheiten. Mittels der frei programmierbaren Anzeigefunktion kann damit dem Bedienfeld des Fernsteuersenders ein beliebiges Aussehen gegeben werden und somit die Tastenanordnung, Tastenbeschriftung und Tastenanzahl des original Gerätes simuliert werden. Der Benutzer hat damit dasselbe Erscheinungsbild wie beim original Gerät. Durch die ebenfalls frei programmierbare Touch-Screen-Funktion werden vorbestimmten Flächenbereichen vorbestimmte Tastenfunktionen zugeordnet, über die dann der jeweilige Infrarot-Code abgerufen werden kann.

Damit ist es auch möglich, in einem Fernsteuersender die Fernsteuerung für mehrere verschiedene Geräte unterzubringen. Wird eines von mehreren Geräten ausgewählt, wie z.B. ein Fernseher, ein Videorecorder oder ähnliches, so wird auf dem Sensorbildschirm das entsprechende Layout angezeigt und die Tastenzuordnung entsprechend umprogrammiert. Die Auswahl der einzelnen Geräte kann außerhalb der Folie durch separate Tasten oder Schalter erfolgen.

Das Programmiergerät ist neben den aus der DE 40 25 302 C2 bekannten Komponenten mit Bilderfassungs- und Bildbearbeitungskomponenten ausgestattet. Die Bilderfassungskomponenten sind beispielsweise eine Digitalkamera und/oder ein Scanner, mit denen das Aussehen (Layout) der original Fernsteuerung erfaßt werden kann, um es ggf. nach einer Bildbearbeitung auf den Sensorbildschirm übertragen zu können. Die entsprechenden Bilddaten können auch über ein Lesegerät für digitale Daten, wie z.B. ein CD-Abspielgerät, ein Diskettenlaufwerk oder ähnliches, eingegeben werden, sofern sie z.B. vom Hersteller des original Gerätes in digitalisierter Form vorliegen. Weiter hat das Programmiergerät eine Bildbearbeitungsfunktion, die durch Software realisiert ist, um die durch die Kamera oder den Scanner ermittelten Bilddaten an die programmierbare Folie des Fernsteuersenders anzupassen, insbesondere hinsichtlich einer Skalierung.

Vom Programmiergerät werden sowohl die Bilddaten als auch die IR-Code-Daten an den Fernsteuersender übertragen. Dies kann mittels Kabel, Infrarot- oder Hochfrequenzübertragung oder auch mittels Licht unterschiedlicher Wellenlängen erfolgen.

Im folgenden wird die Erfindung anhand eines Ausführungsbeispieles im Zusammenhang mit der Zeichnung ausführlicher erläutert. Es zeigt:
- Fig. 1: ein Prinzipschaltbild eines Fernsteuersenders und einer Programmiereinrichtung zur Durchführung des Verfahrens nach der Erfindung; und
- Fig. 2: ein Beispiel des Layouts eines mit dem Verfahren nach der Erfindung programmierten Fernsteuersenders.

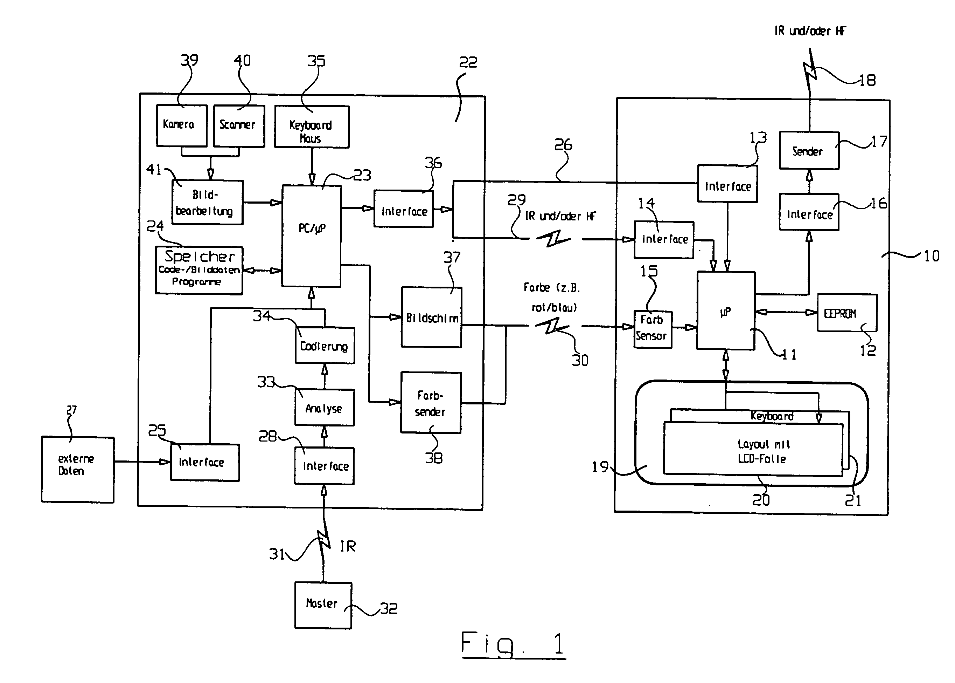

Zunächst wird auf Fig. 1 Bezug genommen. Ein Fernsteuersender 10 enthält einen Mikroprozessor 11, der mit einem Speicher 12, der beispielsweise ein EEPROM sein kann, verbunden ist. Zur Verbindung mit einer Programmiereinrichtung hat der Fernsteuersender 10 hier alternativ oder kumulativ drei Eingabeschnittstellen 13, 14 und 15, die jeweils mit dem Mikroprozessor 11 verbunden sind. Über die Eingabeschnittstelle 13 werden Daten über ein Kabel 26, über die Eingabeschnittstelle 14 über eine Infrarot- oder Hochfrequenzstrecke 29 und über die Eingabeschnittstelle 15 über eine Lichtstrecke 30 übertragen.

Weiter ist an dem Mikroprozessor 11 eine Ausgabeschnittstelle 16 angeschlossen, über die Daten an einen Infrarot-Sender 17 übertragen werden, der in bekannter Weise codierte Infrarot-Signale über eine Infrarot-Strecke 18 an ein fernzusteuerndes Gerät sendet. Statt der Infrarot-Strecke kann auch eine HF-Strecke (Hochfrequenzstrecke) vorgesehen sein.

Weiter ist an den Mikroprozessor 11 ein programmierbarer Sensorbildschirm 19 angeschlossen, die die Funktionen einer programmierbaren Anzeigeeinheit 20 und einer programmierbaren Tastatur 21 aufweist. Die Anzeigeeinheit 20 ist beispielsweise eine LCD-Folie oder eine LCD-Anzeigeeinheit, auf der beliebige Bilder dargestellt werden können. Hierauf wird entsprechend den oben genannten Bilddaten eine Abbildung von Tasten und deren Beschriftung angezeigt.

Die Funktion der Tastatur 21 ist durch einen sog. Touch-Screen-Funktion realisiert, für die verschiedene Realisierungsmöglichkeiten im Stand der Technik existieren, sei es durch kapazitive Näherungsschalter oder durch druckempfindliche Schalter. Die Funktion der Tastatur 21 ist räumlich in die Anzeigeeinheit 20 integriert, so daß die Schaltfunktionen der Tastatur jeweils vorbestimmten Flächenbereichen der Anzeigeeinheit 21 zugeordnet sind, auf welcher das Symbol einer entsprechenden Taste abgebildet ist. Auch die Funktion der Tastatur 21 ist frei programmierbar, d.h. bei Berührung oder Annäherung eines Fingers an einen vorbestimmten Bereich der Anzeigeeinheit wird der diesem Bereich zugeordnete "Schalter" der Tastatur 21 aktiviert, worauf über den Mikroprozessor 11 ein vorprogrammierter Code über die Ausgabeschnittstelle 16 an die Sendeeinheit 17 ausgegeben wird.

Die Programmiereinrichtung 22 enthält einen Mikroprozessor 23, an den ein Speicher 24 angeschlossen ist, der sowohl Programme als auch Daten enthält. Anstelle des Mikroprozessors 23 kann auch ein herkömmlicher Personalcomputer verwendet werden, der über Schnittstellen mit Peripheriegeräten der Programmiereinrichtung 22 verbunden ist. Eine dieser Schnittstellen ist eine Eingabeschnittstelle 25, die mit einer Datenquelle 27, beispielsweise einem Diskettenlaufwerk, einer Festplatte oder einem Modem verbunden ist. Über diese Schnittstelle können externe Daten eingegeben werden und zwar sowohl hinsichtlich der Codierung der Tastatur 21 (Code-Daten) als auch hinsichtlich des Layouts der Anzeigeeinheit 20 (Bilddaten).

Eine weitere Eingabeschnittstelle 28 ist hier als Infrarot-Empfänger ausgebildet, der über eine Infrarot-Strecke 31 von einem Sender 32 Infrarot-Signale empfängt. Der Sender 32 kann als "Master"-Sender aufgefaßt werden, dessen Funktionen von dem Fernsteuersender 10 "gelernt" werden sollen. Der Eingabeschnittstelle 28 ist ein Analysator 33 nachgeschaltet, der die empfangenen IR-Signale analysiert. Dabei werden beispielsweise die Art der Modulation, die Frequenz der Modulation, Impulsdauer, Pausendauer etc. analysiert. Das Ergebnis dieser Analyse wird anschließend in einer Codiereinheit 34 codiert, womit dann der in den Speicher 12 des Fernsteuersenders 10 einzuschreibende Code festgelegt ist. Die Zuordnung der einzelnen Codes zu den entsprechenden Tasten kann unter Steuerung durch eine Tastatur 35 erfolgen. Durch sequentielles Betätigen aller Tasten des Senders 32 können die entsprechenden Signale abgefragt und nach Analyse und Codierung sowohl im Speicher 24 abgelegt als auch über eine Ausgabeschnittstelle 36 einen Bildschirm 37 der Programmiereinrichtung 22 oder einen Farbsender 38 an den Fernsteuersender 10 übertragen werden. Die Ausgabeschnittstelle 36 kann entweder über das Kabel 26 oder über eine Infrarot- und/oder HF-Strecke 29 die entsprechenden Daten übertragen.

Eine andere Möglichkeit der Datenübertragung erfolgt über die Lichtstrecke 30, über welche farblich codierte Signale an die als Farbsensor ausgebildete Eingabeschnittstelle 15 des Fernsteuersenders 10 übertragen werden. Als Farbsender kann dabei ein Bildschirm 37 dienen oder ein Farbsender 38, der mindestens zwei lichtemittierende Dioden aufweist, die Licht unterschiedlicher Wellenlängen ausstrahlen. Vorzugsweise liegen diese Wellenlängen im Bereich des sichtbaren Lichtes möglichst weit auseinander, wie z.B. die Farben rot und blau. Auch über den Bildschirm 37 können entsprechende Farbsignale unterschiedlicher Farben gesendet werden, beispielsweise indem der gesamte Bildschirm impulsweise eine Farbe einnimmt. Zusätzlich zu der farblichen Codierung kann auch eine zeitliche Codierung vorgenommen werden. Es können auch mehr als zwei Farben verwendet werden, womit die Übertragungsgeschwindigkeit erhöht wird.

Als weitere Eingabeschnittstellen hat die Programmiereinrichtung 22 eine Kamera 39 und/oder einen Scanner 40, mittels derer das Layout des Original- oder Master-Fernsteuersenders in digitalisierter Form erfaßt und ggf. nach einer Bildbearbeitung, die hier als Funktionsblock 41 angedeutet ist, ebenfalls an den Fernsteuersender 10 übertragen wird, womit das Layout der Anzeigeeinheit 20 festgelegt wird. Dieses Layout wird in dem Speicher 12 gespeichert und nach Abruf auf der Anzeigeeinheit 20 abgebildet. Die Bildbearbeitung 41 erfolgt in der Praxis selbstverständlich mittels des Mikroprozessors 23 in Zusammenwirken mit einem im Speicher 24 abgelegten Bildbearbeitungsprogramm.

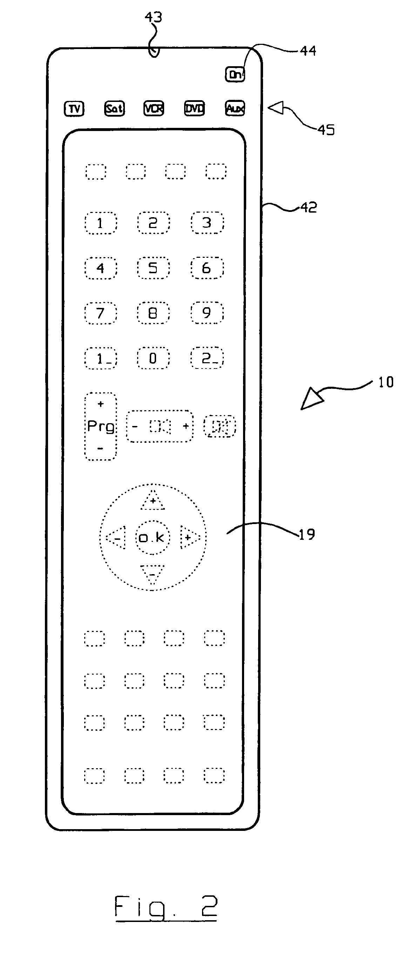

Fig. 2 zeigt ein Ausführungsbeispiel eines Fernsteuersenders 10 in Draufsicht. An der Oberseite eines üblichen Gehäuses 42 ist die programmierbare Folie 19 angebracht, die den größten Teil der Oberfläche des Gehäuses 42 überdeckt. Wie üblich ist an der Stirnseite des Gehäuses eine Infrarot-Sendediode 43 angebracht. Weiter können an dem Gehäuse und zwar außerhalb der programmierbaren Folie 19 weitere Tasten 44 und 45 angebracht sein. Die Taste 44 ist hier als Ein-/Ausschalter konfiguriert, während die Reihe von Tasten 45 für die Auswahl unterschiedlicher Geräte, wie z.B. eines Fernsehers (CV), eines Satellitenempfängers (SAT), eines Videorecorders (VCR), eines DVD-Spielers (DVD) und eines weiteren Gerätes (AUX) vorgesehen sind. Statt der Tasten 45 kann auch ein mehrstufiger Schiebe- oder Drehschalter vorgesehen sein.

Auf der programmierbaren Folie 19 sind entsprechend dem Layout des ausgewählten Gerätes Abbildungen und Beschriftungen von Tasten zu sehen. Da es sich hier sozusagen um "virtuelle" Tasten handelt, sind sie gestrichelt abgebildet. Durch Berühren des entsprechenden Bereiches auf der programmierbaren Folie wird über die Touch-Screen-Funktion ein entsprechender Kontakt betätigt bzw. ein Signal erzeugt, das dann über den Mikroprozessor 11 den zugeordneten Code erzeugt, der letztendlich als codiertes Infrarot-Signal von der Infrarot-Sendediode 43 abgestrahlt wird.

Mit der Erfindung erreicht man die Vorteile, daß eine universelle und damit auch in Großserie kostengünstig herzustellende Fernsteuerung geschaffen wird, die nicht nur individuell nach einem oder mehreren von vielen zur Verfügung stehenden Codes programmiert werden kann sondern auch hinsichtlich Tastenanordnung, Tastenbeschriftung, Tastengröße etc. (zusammengefaßt "Layout" genannt) frei programmierbar ist, so daß der Endbenutzer stets die ihm gewohnte Fernsteuerung vorfindet, auch wenn er das Original gegen die Fernsteuerung nach der Erfindung austauscht.

Ein weiterer Vorteil liegt darin, daß man nicht mehr wie bisher unterschiedliche Bedruckungsvarianten benötigt, was eine zusätzliche Kostenersparnis in der Produktion bei einem hohen Maß an Flexibilität bringt.

## Patentansprüche

1. Verfahren zum Programmieren eines Fernsteuersenders (10), der einen Mikroprozessor (11) aufweist, der mit folgenden Funktionsgruppen in Wirkverbindung steht:
- einer Eingabeschnittstelle (14, 15),
- einer Ausgabeschnittstelle (16),
- einem Speicher (12) für Fernsteuercodes und
- einer Bedieneinheit (21), bei deren Betätigung vorbestimmte Fernsteuercodes aus dem Speicher (12) abgerufen und über die Ausgabeschnittstelle (16) an eine Sendeeinheit (17) ausgegeben werden,
wobei die Bedieneinheit als Sensorbildschirm (19) ausgebildet ist,
wobei über die Eingabeschnittstelle (14, 15) beliebige Bilddaten zur Speicherung in dem Speicher (12) und zur Darstellung auf dem Sensorbildschirm (19) eingebbar sind und
zusätzlich über die Eingabeschnittstelle (14, 15) Fernsteuercodes eingebbar sind, die vorbestimmten Bereichen des Sensorbildschirms (19) zugeordnet sind,
wobei eine Programmiereinheit mit einem Mikroprozessor (23), einem Speicher (24), mindestens einer Eingabeschnittstelle (25, 28) und mindestens einer Ausgabeschnittstelle (36, 37, 38) die Daten zu mindestens einer der Eingabeschnittstellen (13, 14, 15) des programmierbaren Fernsteuersenders (10) überträgt,
wobei Bilddaten im Speicher (24) ablegbar und über die mindestens eine Ausgabeschnittstelle (36, 37, 38) an den programmierbaren Fernsteuersender (10) übertragbar sind,
wobei über die Eingabeschnittstelle (25, 28) der Programmiereinrichtung (22) zusätzlich Fernsteuercodes für diesen beliebigen Fernsteuersender eingebbar sind, die in Zuordnung zu den Bilddaten im Speicher (24) ablegbar und ebenfalls über die mindestens eine Ausgabeschnittstelle (36, 37, 38) an den programmierbaren Fernsteuersender (10) übertragbar sind,
**dadurch gekennzeichnet,**
**daß** die Bilddaten eines beliebigen vorhandenen Fernsteuersenders mit einem Bilderfassungsgerät (39, 40) erfasst werden und auf dem Sensorbildschirm (19) als Tastatur dargestellt werden.

2. Verfahren nach Anspruch 1, **dadurch gekennzeichnet,**
**daß** die Bilddaten von einer Digitalkamera (39) oder einem Scanner (40) erfasst werden.

3. Verfahren nach Anspruch 2, **dadurch gekennzeichnet,**
**daß** die von der Kamera (39) oder dem Scanner (40) erfassten Bilddaten mittels eines Bildbearbeitungsprogramms (41) verändert werden.

4. Verfahren nach den Ansprüchen 1, 2 oder 3, **dadurch gekennzeichnet,**
**daß** die Eingabeschnittstelle (14, 15) als Infrarot-Empfänger, HF-Empfänger oder Farblicht-Empfänger ausgebildet ist.

5. Verfahren nach Anspruch 4, **dadurch gekennzeichnet,**
**daß** die Eingabeschnittstelle (15) als Farblicht-Empfänger für mindestens zwei unterschiedliche Farben ausgebildet ist.

6. Verfahren nach Anspruch 5, **dadurch gekennzeichnet,**
**daß** die Ausgabeschnittstelle ein Bildschirm (37) oder ein Farblichtsender (38) ist, die Lichtimpulse mit mindestens zwei unterschiedlichen Farben an die als Farbsensor (15) ausgebildete Eingabeschnittstelle des programmierbaren Fernsteuersenders (10) aussenden.

7. Verfahren nach Aspruch-1, **dadurch gekennzeichnet,**
**daß** der Sensorbildschirm (19) als LCD-Folie (20) in Kombination mit einer berührungsempfindlichen Schaltfolie (21) ausgebildet ist.

## Claims

1. Method for programming a remote control transmitter (10) which has a microprocessor (11) which is actively connected to the following functional groups: an input interface (14, 15), an output interface (16), a memory (12) for remote control codes and a user device (21), during the activation of which predetermined remote control codes are requested from the memory (12) and output to a transmitter unit (17) via the output interface (16), the user device being configured as a touch screen (19), it being possible to input any image data via the input interface (14, 15) for storing in the memory (12) and for presenting on the touch screen (19), and it also being possible to input remote control codes which are associated with predetermined regions of the touch screen (19) via the input interface (14, 15), a programming unit with a microprocessor (23), a memory (24), at least one input interface (25, 28) and at least one output interface (36, 37, 38) transmitting the data to at least one of the input interfaces (13, 14, 15) of the programmable remote control transmitter (10), it being possible to file image data in the memory (24) and to transmit said image data to the programmable remote control transmitter (10) via the at least one output interface (36, 37, 38), it also being possible to input remote control codes for this arbitrary remote control transmitter via the input interface (25, 28) of the programming device (22), which remote control codes may be filed in the memory (24) in association with the image data and may also be transmitted to the programmable remote control transmitter (10) via the at least one output interface (36, 37, 38), **characterised in that** the image data of any present remote control transmitter is detected using an image detection device (39, 40) and represented on the touch screen (19) as a keypad.

2. Method according to claim 1, **characterised in that** the image data is detected by a digital camera (39) or a scanner (40).

3. Method according to claim 2, **characterised in that** the image data detected by the camera (39) or the scanner (40) is altered by an image processing program (41).

4. Method according to claim 1, claim 2 or claim 3, **characterised in that** the input interface (14, 15) is configured as an infrared receiver, an HF receiver or a coloured light receiver.

5. Method according to claim 4, **characterised in that** the input interface (15) is configured as a coloured light receiver for at least two different colours.

6. Method according to claim 5, **characterised in that** the output interface is a screen (37) or a coloured light transmitter (38) which transmits light pulses with at least two different colours to the input interface, configured as a colour sensor (15), of the programmable remote control transmitter (10).

7. Method according to claim 1, **characterised in that** the touch screen (19) is configured as an LCD film (20) combined with a touch-sensitive circuit foil (21).

## Revendications

1. Procédé de programmation d'une télécommande (10) comprenant un microprocesseur (11) qui est en relation active avec les groupes fonctionnels suivants :
- une interface d'entrée (14, 15),
- une interface de sortie (16),
- une mémoire (12) pour des codes de télécommande et
- une unité de manipulation (21) dont l'actionnement provoque l'extraction de codes de télécommande prédéterminés hors de la mémoire (12) et leur transfert par l'intermédiaire de l'interface de sortie (16) à une unité d'émission (17),
dans lequel l'unité de manipulation est configurée sous forme d'un écran capteur (19),
dans lequel des données d'images quelconques devant être mémorisées dans la mémoire (12) et devant être représentées sur l'écran capteur (19) peuvent être introduites par l'intermédiaire de l'interface d'entrée (14, 15),
dans lequel des codes de télécommande qui sont attribués à des zones prédéterminées de l'écran capteur (19) peuvent être introduits en supplément par l'intermédiaire de l'interface d'entrée (14, 15),
dans lequel une unité de programmation avec un microprocesseur (23), avec une mémoire (24), avec au moins une interface d'entrée (25, 28) et avec au moins une interface de sortie (36, 37, 38) transmet les données à au moins une des interfaces d'entrée (13, 14, 15) de la télécommande programmable (10),
dans lequel des données d'images peuvent être stockées dans la mémoire (24) et peuvent être transmises par l'intermédiaire de l'une au moins des interfaces de sortie (36, 37, 38) à la télécommande programmable (10)
dans lequel par l'intermédiaire de l'interface d'entrée (25, 28) du dispositif de programmation (22) peuvent être introduits en supplément des codes de télécommande pour cette télécommande quelconque qui, en étant attribués aux données d'images, peuvent être stockés dans la mémoire (24) et peuvent également être transmis par l'intermédiaire de l'une au moins des interfaces de sortie (36, 37, 38) à la télécommande programmable (10),
**caractérisé en ce**
**que** les données d'images d'une télécommande quelconque qui est disponible sont saisies au moyen d'un équipement de saisie d'images (39, 40) et sont représentées en tant que clavier sur l'écran capteur (19).

2. Procédé selon la revendication 1, **caractérisé en ce que** les données d'images sont saisies par une caméra numérique (39) ou par un scanner (40).

3. Procédé selon la revendication 2, **caractérisé en ce que** les données d'images saisies par la caméra numérique (39) ou par le scanner (40) sont modifiées à l'aide d'un programme de traitement d'images (41).

4. Procédé selon les revendications 1, 2 ou 3, **caractérisé en ce**
**que** l'interface d'entrée (14, 15) est configurée sous forme d'un récepteur d'infrarouges, d'un récepteur HF ou d'un récepteur de lumière colorée.

5. Procédé selon la revendication 4, **caractérisé en ce que** l'interface d'entrée (15) est configurée sous forme d'un récepteur de lumière colorée pour au moins deux couleurs différentes.

6. Procédé selon la revendication 5, **caractérisé en ce que** l'interface de sortie est un écran (37) ou un émetteur de lumière colorée (38) qui émettent des impulsions lumineuses d'au moins deux couleurs différentes vers l'interface d'entrée de la télécommande programmable (10) qui est configurée sous forme d'un capteur de couleurs (15).

7. Procédé selon la revendication 1, **caractérisé en ce que** l'écran capteur (19) est configuré sous forme d'un film à cristaux liquides (20) combiné avec un film de commande tactile (21).
